(19) **Europäisches Patentamt European Patent Office Office européen des brevets**

(11) **EP 2 131 494 B1**

(12) **FASCICULE DE BREVET EUROPEEN**

(45) Date de publication et mention
de la délivrance du brevet:
**23.05.2012 Bulletin 2012/21**

(51) Int Cl.:
***H03H 19/00*** *(2006.01)*

(21) Numéro de dépôt: **09162124.3**

(22) Date de dépôt: **05.06.2009**

(54) **Circuit à capacités commutées à consommation réduite**

Schaltkreis mit geschalteten Kapazitäten mit geringem Energieverbrauch

Circuit with switched capacitances with reduced consumption

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **06.06.2008 FR 0853748**

(43) Date de publication de la demande:
**09.12.2009 Bulletin 2009/50**

(73) Titulaire: **Dolphin Integration**
**38240 Meylan (FR)**

(72) Inventeurs:
• **COSTA DOMINGUES, Christian**
**38530, PONTCHARRA (FR)**
• **De Rotalier, Laetitia**
**38000, GRENOBLE (FR)**

(74) Mandataire: **de Beaumont, Michel**
**1bis, rue Champollion**
**38000 Grenoble (FR)**

(56) Documents cités:
JP-A- 61 052 018      JP-A- 63 299 406
US-A1- 2002 089 366      US-B1- 6 509 790

**EP 2 131 494 B1**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

# EP 2 131 494 B1

**Description**

<u>Domaine de l'invention</u>

La présente invention concerne les circuits à capacités commutées et plus précisément les circuits à capacités commutées à très haute résolution.

<u>Exposé de l'art antérieur</u>

Un circuit à capacités commutées comprend au moins un condensateur dont au moins une armature est alternativement connectée à une fréquence de commutation à l'une ou l'autre de deux bornes par des interrupteurs. En fonctionnement, l'ensemble formé par le condensateur et les interrupteurs associés est équivalent à une résistance égale au rapport entre la période de commutation et la capacité du condensateur. Les circuits à capacités commutées présentent de nombreux avantages. En effet, ils permettent de simuler une résistance variable qui dépend de la fréquence de commutation. C'est pourquoi les circuits à capacités commutées sont utilisés notamment pour la réalisation de filtres dont la fréquence de coupure dépend de la fréquence de commutation. En outre, pour des technologies de fabrication équivalentes, un circuit à capacités commutées occupe une surface plus faible lorsqu'il est réalisé de façon intégrée que celle qu'occuperait un circuit équivalent réalisé avec des résistances véritables. De plus, pour des technologies de fabrication équivalentes, la capacité d'un condensateur réalisé de façon intégrée peut être obtenue avec une précision supérieure à celle d'une résistance.

Le document JP 63299406 décrit un tel circuit à capacités commutées permettant de réduire la surface et la consommation. La tendance actuelle est à la réalisation de circuits à capacités commutées à très haute résolution, c'est-à-dire pour lesquels le rapport signal-sur-bruit, ou SNR (signal-to-noise ratio), est supérieur à une centaine de décibels. Pour un circuit à capacités commutées classique, ceci requiert d'augmenter les capacités des condensateurs du circuit à des valeurs pouvant dépasser plusieurs centaines de picofarads. L'augmentation des capacités des condensateurs se traduit par une augmentation indésirable de la consommation totale du circuit à capacités commutées. En outre, il est généralement difficile de réaliser de façon intégrée des condensateurs à capacités élevées.

<u>Résumé de l'invention</u>

La présente invention vise un circuit à capacités commutées permettant d'obtenir un SNR élevé tout en conservant une consommation réduite.

Un autre objet de la présente invention est la réalisation d'un circuit à capacités commutées occupant une surface réduite lorsqu'il est réalisé de façon intégrée.

Dans ce but, la présente invention prévoit un circuit à capacités commutées comprenant au moins un premier condensateur et un circuit de commutation d'au moins une armature du premier condensateur alternativement à l'une et l'autre de deux bornes à une fréquence de commutation. Le circuit comprend, en outre, un deuxième condensateur relié au premier condensateur à un noeud et un circuit de filtrage reliant le noeud à une masse virtuelle seulement pour des fréquences appartenant à une plage de fréquences.

Selon un exemple de réalisation, le circuit de filtrage est adapté à relier le noeud à la masse virtuelle seulement pour des fréquences inférieures à une fréquence de seuil supérieure à la moitié de la fréquence de commutation.

Selon un exemple de réalisation, le circuit de filtrage comprend un amplificateur à entrées différentielles dont une entrée est reliée au noeud et ayant une fréquence de coupure principale, la fréquence de seuil du circuit de filtrage correspondant à la fréquence de coupure principale.

Selon un exemple de réalisation, le circuit de filtrage comprend au moins un filtre actif comportant au moins un composant électronique actif et au moins un filtre passif comportant au moins un composant électronique passif.

Selon un exemple de réalisation, la capacité du deuxième condensateur est inférieure à la capacité du premier condensateur.

Selon un exemple de réalisation, le premier condensateur comprend des première et deuxième armatures, le circuit comprenant des première, deuxième et troisième bornes ; un premier interrupteur reliant la première borne à la première armature du premier condensateur ; un deuxième interrupteur reliant la deuxième borne à la première armature du premier condensateur ; un troisième interrupteur reliant la troisième borne à la seconde armature du premier condensateur ; et un quatrième interrupteur reliant le noeud à la seconde armature du premier condensateur, les premier et quatrième interrupteurs étant commandés par un premier signal binaire et les deuxième et troisième interrupteurs étant commandés par un deuxième signal binaire, les premier et deuxième signaux binaires étant non recouvrants.

Selon un exemple de réalisation, le circuit de filtrage comprend un amplificateur opérationnel comprenant une entrée reliée audit noeud et une sortie reliée à ladite entrée par l'intermédiaire du deuxième condensateur, la fréquence de seuil du circuit de filtrage correspondant à la fréquence de coupure de l'amplificateur opérationnel.

Selon un exemple de réalisation, la deuxième borne est reliée à une source du potentiel de référence et l'amplificateur opérationnel comprend une entrée supplémentaire reliée à ladite source du potentiel de référence.

Selon un exemple de réalisation, le circuit comprend, en outre, un cinquième interrupteur aux bornes du deuxième condensateur, le cinquième interrupteur étant fermé, lorsque les premier et quatrième interrupteurs sont fermés, pendant une première durée et ouvert pendant une seconde durée.

Selon un exemple de réalisation, le circuit comprend, en outre, un troisième condensateur comprenant des troisième et quatrième armatures, l'amplificateur opérationnel comprenant une entrée supplémentaire reliée à un noeud supplémentaire et une sortie supplémentaire reliée à l'entrée supplémentaire par l'intermédiaire d'un quatrième condensateur ; des quatrième et cinquième bornes ; un sixième interrupteur commandé par le premier signal reliant la quatrième borne à la troisième armature du troisième condensateur ; un septième interrupteur commandé par le second signal reliant la cinquième borne à la quatrième armature du troisième condensateur ; et un huitième interrupteur commandé par le premier signal reliant le noeud supplémentaire à la quatrième armature du troisième condensateur, la deuxième borne étant située entre la troisième armature du troisième condensateur et le cinquième interrupteur.

Brève description des dessins

Ces objets, caractéristiques et avantages, ainsi que d'autres seront exposés en détail dans la description suivante d'exemples de réalisation particuliers faite à titre non-limitatif en relation avec les figures jointes parmi lesquelles :

la figure 1 représente, de façon schématique, un exemple de réalisation classique d'un circuit à capacités commutées ;

la figure 2 représente un circuit électrique servant à modéliser la fonction de transfert en bruit du circuit de la figure 1 ;

la figure 3 représente schématiquement l'évolution de la densité spectrale de puissance du bruit en sortie du circuit de la figure 2 ;

les figures 4 et 5 sont des figures analogues respectivement aux figures 1 et 2 d'une variante du circuit de la figure 1 ;

la figure 6 représente un circuit électrique illustrant le principe de fonctionnement d'un circuit à capacités commutées selon l'invention ;

la figure 7 représente un exemple de réalisation d'un circuit à capacités commutées selon l'invention ;

la figure 8 représente schématiquement l'évolution de la densité spectrale de puissance du bruit en sortie du circuit de la figure 7 ;

la figure 9 représente une variante de réalisation du circuit de la figure 7 ;

les figures 10 et 12 représentent deux exemples de réalisation classiques d'un intégrateur à capacités commutées ; et

les figures 11 et 13 représentent deux exemples de réalisation d'un intégrateur à capacités commutées selon l'invention.

Description détaillée

Par souci de clarté, de mêmes éléments ont été désignés par de mêmes références aux différentes figures. Par ailleurs, dans la suite de la description, on utilise la même référence pour désigner un élément capacitif, ou condensateur, et sa capacité et on utilise la même référence pour désigner un élément résistif, ou résistance, et la valeur de sa résistance. En outre, l'expression "circuit à capacités commutées" est utilisée de façon générale et peut désigner un circuit comprenant un seul condensateur dont au moins l'une des armatures est commutée entre deux bornes.

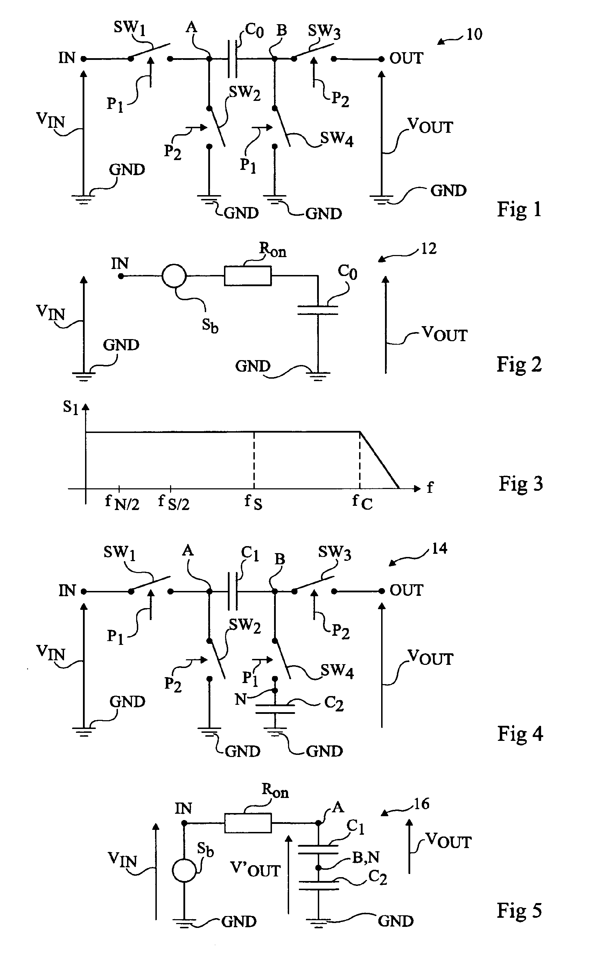

La figure 1 représente un exemple classique d'un circuit à capacités commutées 10 comprenant une borne d'entrée IN et une borne de sortie OUT. On appelle $V_{IN}$ la tension entre la borne IN et une source d'un potentiel de référence, par exemple la masse GND, et $V_{OUT}$ la tension entre la borne OUT et la masse GND. Le circuit 10 comprend un condensateur $C_0$ dont une armature est reliée à un noeud A et l'autre armature est reliée à un noeud B. Le noeud A est relié à la borne IN par l'intermédiaire d'un interrupteur $SW_1$ commandé par un signal de commande $P_1$. Le noeud A est, en outre, relié à la masse GND par l'intermédiaire d'un interrupteur $SW_2$ commandé par un signal de commande P2. Le noeud B est relié à la borne OUT par l'intermédiaire d'un interrupteur $SW_3$ commandé par le signal $P_2$. Le noeud B est, en outre, relié à la masse GND par l'intermédiaire d'un interrupteur $SW_4$ commandé par le signal $P_1$. A titre d'exemple, les signaux de commande $P_1$ et $P_2$ sont des signaux binaires alternant entre un état haut, noté "1", et un état bas, noté "0". A titre d'exemple, lorsque le signal $P_1$ est à "1" (signal $P_2$ à "0"), les interrupteurs $SW_1$ et $SW_4$ sont fermés et les interrupteurs $SW_2$ et $SW_3$ sont ouverts. Lorsque le signal $P_1$ est à "0" (signal $P_2$ à "1"), les interrupteurs $SW_1$ et $SW_4$ sont ouverts et les interrupteurs $SW_2$ et $SW_3$ sont fermés. Les signaux $P_1$ et $P_2$ sont non recouvrants, c'est-à-dire qu'ils ne sont pas simultanément à l'état pour lequel ils commandent la fermeture des interrupteurs associés (l'état haut dans le présent exemple). Toutefois, les signaux $P_1$ et $P_2$ peuvent éventuellement être simultanément à l'état pour lequel ils commandent l'ouverture des interrupteurs associés (l'état bas dans le présent exemple). A titre d'exemple, les signaux $P_1$ et $P_2$ sont complémentaires, c'est-à-dire que le signal $P_1$ est à l'état bas lorsque le signal $P_2$ est à l'état haut et inversement. A titre d'exemple, les signaux $P_1$ et $P_2$ sont périodiques de fréquence $f_S$ (appelée par la suite fréquence de commutation ou fréquence d'échantillonnage) et de période $T_S$. On appelle $\alpha$ le rapport cyclique du signal $P_1$. Ceci signifie que sur une période $T_S$, le signal $P_1$ est à l'état haut pendant la durée $\alpha T_S$ et à l'état bas pendant la durée ($\alpha$-1)$T_S$, $\alpha$ étant strictement inférieur à 1. A titre d'exemple, le rapport $\alpha$ est égal à 1/2.

De façon classique, le circuit 10 est équivalent à une résistance R placée entre les bornes IN et OUT et égal à :

$$R = T_S/C_0 = 1/(C_0 f_S) \qquad (1)$$

La figure 2 représente un circuit 12 équivalent au circuit 10 utilisé pour estimer la densité spectrale de puissance de bruit en sortie du circuit 10. Dans le cas où les interrupteurs $SW_1$ et $SW_4$ sont réalisés par des transistors MOS, on peut considérer que, lorsque les interrupteurs $SW_1$ et $SW_4$ sont fermés, le circuit 10 est équivalent à une source $S_b$ d'un bruit thermique en série avec une résistance $R_{ON}$ qui correspond à la résistance interne à l'état passant des transistors MOS. La tension $V_{IN}$ fournie par la source de bruit $S_b$ est filtrée par un filtre passe-bas formé par la résistance $R_{ON}$ et le condensateur $C_0$ dont la fonction de transfert H est :

$$H = \frac{1}{1 + j\dfrac{f}{f_C}} \qquad (2)$$

où $f_C$ est la fréquence de coupure du filtre passe-bas et est égale à :

$$f_C = 1/2\pi R_{ON} C_0 \qquad (3)$$

On considère que la fréquence de coupure $f_C$ est beaucoup plus élevée que la fréquence d'échantillonnage $f_S$ pour obtenir une charge convenable du condensateur $C_0$.

La densité spectrale de puissance de bruit $S_0$ fournie par la source $S_b$ est égale à :

$$S_0 = 4kTR_{ON} \qquad (4)$$

La densité spectrale de puissance $S_1$ du bruit en sortie du circuit 12 est égale à :

$$S_1 = \frac{S_0}{1 + \left(\dfrac{f}{f_C}\right)^2} \qquad (5)$$

La figure 3 représente de façon schématique l'évolution de la densité spectrale de bruit $S_1$. Après échantillonnage à la fréquence $f_S$, la densité spectrale de puissance $S_2$ du bruit en sortie du circuit 10 est donnée par la relation suivante :

$$S_2(f) = S_0 \sum_{n=-\infty}^{n=+\infty} \frac{1}{1 + \left(\dfrac{f - nf_S}{f_C}\right)^2} \qquad (6)$$

On appelle $f_N/2$ la fréquence maximale du signal utile à transmettre. Pour respecter le critère de Shannon, la fréquence $f_N/2$ doit être inférieure à la moitié de la fréquence d'échantillonnage $f_S$. La relation (6) met en évidence un repliement dans la bande utile du bruit thermique dû au sous-échantillonnage du bruit large bande.

En pratique, la fréquence $f_N$ est nettement inférieure à la fréquence d'échantillonnage $f_S$. A titre d'exemple, la fréquence $f_S$ est de l'ordre de 1 MHz et la fréquence $f_N$ est de l'ordre de 1 kHz. Une valeur approchée de la valeur efficace de la tension de bruit en sortie du circuit $V_b$ peut être déterminée de façon simple. Dans un premier temps, l'échantillonnage n'est pas pris en compte. La valeur efficace de la tension de bruit $V_b$ en sortie du circuit 12 est donnée par la relation suivante :

$$V_b = \sqrt{\int_0^{+\infty} S_1(f)\,df} = \sqrt{S_0 \int_0^{+\infty} \frac{1}{1 + \left(\frac{f}{f_C}\right)^2}\,df} = \sqrt{S_0 f_C \frac{\pi}{2}} = \sqrt{\frac{kT}{C_0}} \qquad (7)$$

Le bruit étant échantillonné à la fréquence $f_S$, le bruit est ramené dans la bande de fréquence [0, $f_S/2$]. En outre, le signal utile étant dans la bande de fréquence [0, $f_N/2$], on ne conserve qu'une partie du bruit. La valeur efficace de la tension du bruit replié correspond à :

$$V_b = \sqrt{\frac{kT}{C_0 \frac{f_S}{f_C}}} \qquad (8)$$

Une possibilité pour réduire la valeur efficace de la tension de bruit $V_b$ consiste à augmenter la capacité $C_0$. De façon typique, pour obtenir un SNR supérieur à la centaine de décibels, la capacité $C_0$ doit être supérieure à la centaine de picofarads. Un inconvénient est que le circuit 10 fait généralement partie d'un circuit comprenant d'autres condensateurs dont les valeurs dépendent de $C_0$. Par exemple, le circuit 10 peut faire partie d'un intégrateur, comprenant éventuellement un autre condensateur, appelé condensateur d'intégration, dont la capacité peut être égale à environ 10 fois $C_0$. La réalisation de façon intégrée de condensateurs ayant des capacités élevées, par exemple supérieure à plusieurs centaines de picofarads, est difficile. En outre, l'augmentation des capacités des condensateurs des circuits à capacités commutées se traduit par une augmentation de la consommation totale du circuit. Ceci peut être incompatible avec certaines applications pour lesquelles la consommation totale du circuit est un facteur critique.

Pour augmenter le SNR d'un circuit à capacités commutées sans augmenter la capacité du condensateur du circuit, la demanderesse a, dans un premier temps, tenté de remplacer le condensateur $C_0$ par deux condensateurs montés en série pour former un pont capacitif.

La figure 4 représente un circuit à capacités commutées 14 ayant une structure analogue à celle du circuit 10 de la figure 1 à la différence que le condensateur $C_0$ a été remplacé par un condensateur $C_1$ et qu'un condensateur $C_2$ a été ajouté entre l'interrupteur $SW_4$ et la masse GND. La capacité $C_1$ est supérieure à la capacité $C_2$. A titre d'exemple, la capacité $C_1$ peut être égale à dix fois la capacité $C_2$. On désigne par la référence N un noeud situé entre l'interrupteur $SW_4$ et le condensateur $C_2$.

La figure 5 est un circuit électrique 16 équivalent au circuit 14 lorsque les interrupteurs $SW_1$ et $SW_4$ sont fermés et qui en illustre le fonctionnement. La tension $V_{OUT}$ correspond à la tension aux bornes du condensateur C1. On appelle $V'_{OUT}$ la tension entre le noeud A et la masse GND.

La fonction de transfert H' du circuit 16 est :

$$H'(f) = \frac{V_{OUT}}{V_{IN}} = \frac{V_{OUT}}{V'_{OUT}} \frac{V'_{OUT}}{V_{IN}} = \frac{C_2}{C_2 + C_1} \frac{1}{1 + j\frac{f}{f'_C}} \qquad (9)$$

où $f'_C$ est la fréquence de coupure du filtre passe-bas constituée par la résistance $R_{ON}$ et les condensateurs $C_1$ et $C_2$. Aux basses fréquences, la fonction de transfert H' du circuit 16 est sensiblement égale à la fonction de transfert H au circuit 12 multipliée par le facteur d'atténuation $C_2/(C_1+C_2)$. Lorsque la capacité $C_1$ est égale à 10 fois la capacité $C_2$, le facteur d'atténuation est de 1/11. Le pont capacitif formé par les condensateurs $C_1$ et $C_2$ permet donc de réduire la contribution du bruit aux bornes du condensateur $C_1$. On obtient ainsi un gain de 21 dB sur le bruit. Toutefois, l'amplitude du signal utile aux basses fréquences est également diminuée de 21 décibels. Le SNR du circuit 16 n'est donc pas amélioré par rapport à celui du circuit 12.

La demanderesse a mis en évidence que l'on pouvait obtenir l'intégralité du signal utile basse fréquence et seulement une partie du bruit haute fréquence aux bornes du condensateur $C_1$, en reliant le noeud N entre les condensateurs $C_1$ et $C_2$ à une "masse virtuelle basse fréquence".

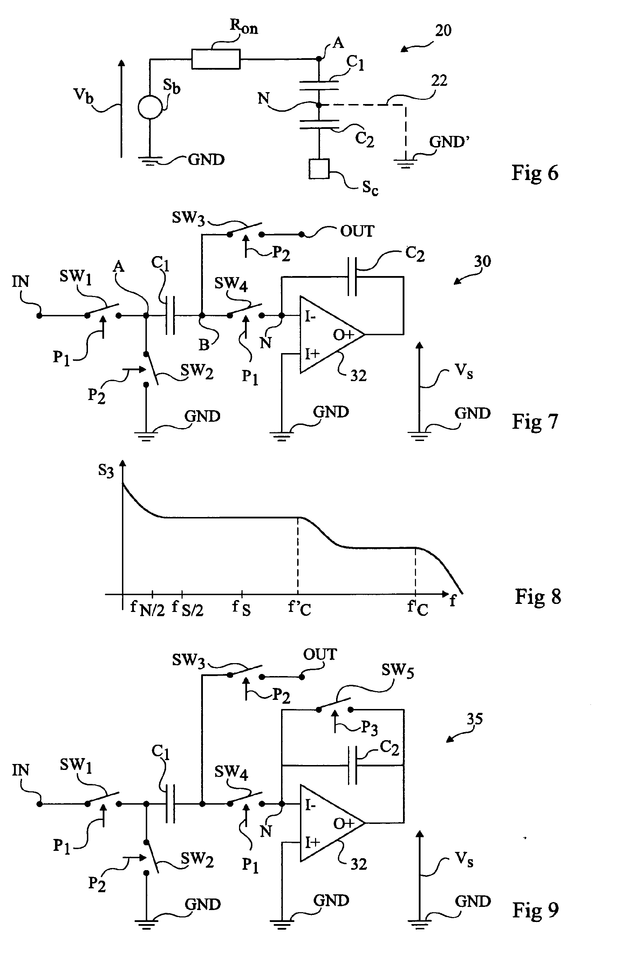

La figure 6 représente un circuit 20 illustrant le principe de masse virtuelle basse fréquence. Le noeud N est relié à une masse virtuelle basse fréquence GND' par une ligne 22 représentée en traits pointillés. Le condensateur $C_2$, du côté opposé au noeud N, est relié à un circuit $S_C$. Pour les basses fréquences, la masse virtuelle GND' est équivalente à la masse GND. Tout se passe comme si le noeud N était alors relié directement à la masse GND en court-circuitant le condensateur $C_2$. Pour les hautes fréquences, tout se passe comme si la masse GND' n'était pas présente et comme si le noeud B était normalement relié au condensateur $C_2$. Aux hautes fréquences, le circuit $S_C$ maintient l'armature du condensateur $C_2$ à un potentiel fixe. Les composantes basses fréquences et en particulier le signal utile ne sont donc vus que par le condensateur $C_1$ tandis que les composantes hautes fréquences (et, en particulier, les composantes hautes fréquences du bruit thermique large bande) sont partagées entre les condensateurs $C_1$ et $C_2$. On bénéficie ainsi de l'atténuation des composantes hautes fréquences du bruit sans atténuation du signal utile. De ce fait, lors du repliement du spectre en raison de l'échantillonnage, la contribution du bruit hautes fréquences dans la bande de fréquence utile est diminuée. De ce fait, pour obtenir un SNR donné, la capacité $C_1$ du circuit 20 selon l'invention peut être inférieure, par exemple d'un rapport pouvant atteindre la dizaine, à la capacité $C_0$ du circuit classique 10. Les capacités des condensateurs $C_1$ et $C_2$ étant faibles, la fabrication du circuit 20 de façon intégrée est facilitée et la consommation du circuit 20 est réduite.

Selon un exemple de réalisation, la masse virtuelle "basse fréquence" est réalisée par un amplificateur à entrées différentielles dont une entrée est reliée au noeud N et dont l'autre entrée est reliée à la masse GND. On appelle fréquence de coupure principale la fréquence la plus faible pour laquelle le gain de l'amplificateur chute de 3 dB par rapport au gain maximal de l'amplificateur. L'amplificateur peut comprendre des composants actifs (par exemple un amplificateur opérationnel) et éventuellement des composants passifs (résistance, condensateur, etc.).

La figure 7 représente un exemple de réalisation d'un circuit à capacités commutées 30 à masse virtuelle. Le circuit 30 reprend l'ensemble des éléments du circuit 14 de la figure 4, à l'exception du fait que le noeud N est relié à une entrée inverseuse I- d'un amplificateur opérationnel 32. L'entrée non inverseuse I+ de l'amplificateur opérationnel 32 est reliée à la masse GND. Le condensateur $C_2$ est prévu entre le noeud N et la sortie O+ de l'amplificateur opérationnel 32. De façon classique, l'amplificateur opérationnel 32 a une fréquence de coupure $f'_C$ de l'ordre de 1 à quelques Mégahertz, par exemple 2 MHz, qui est inférieure à la fréquence de coupure $f_C$ et est supérieure à la moitié de la fréquence de commutation $f_S$ des interrupteurs $SW_1$ à $SW_4$. Dans la suite de la description, on appelle basses fréquences des fréquences inférieures à la fréquence de coupure $f'_C$ et hautes fréquences des fréquences supérieures à la fréquence de coupure $f'_C$.

Le fonctionnement du circuit 30 va être décrit lorsque les interrupteurs $SW_1$ et $SW_4$ sont fermés. Pour des fréquences inférieures à la fréquence de coupure $f'_C$, l'amplificateur opérationnel 32 fonctionne normalement. En particulier, les tensions aux entrées inverseuse I- et non inverseuse I+ de l'amplificateur opérationnel 32 sont égales. Le noeud N est donc bien relié directement à la masse GND. Pour des fréquences supérieures à la fréquence de coupure $f'_C$, l'amplificateur opérationnel 32 ne fonctionne plus correctement, et tout se passe comme s'il n'était pas présent, la sortie O+ étant à haute impédance. Les composantes hautes fréquences sont alors bien réparties entre les condensateurs $C_1$ et $C_2$.

La figure 8 représente de façon schématique un exemple d'évolution de la densité spectrale de puissance de bruit $S_3$ en sortie du circuit 30 sans tenir compte de l'échantillonnage. Aux basses fréquences, on observe la contribution du bruit en 1/f de l'amplificateur opérationnel 32, également appelé bruit de scintillation ou bruit rose (en anglais flicker noise). L'amplitude de la densité spectrale de puissance de bruit $S_3$ en sortie du circuit 30 diminue pour les fréquences supérieures à $f'_C$. Lors de l'échantillonnage, les composantes hautes fréquences du bruit thermique sont repliées sur l'intervalle $[0, f_S/2]$. Du fait que ces composantes hautes fréquences ont été atténuées, leur contribution dans la bande utile $[0, f_N/2]$ est réduite.

Il est avantageux que le condensateur $C_2$ soit le plus petit possible par rapport à $C_1$ pour améliorer l'atténuation des composantes hautes fréquences. Toutefois, lorsque les interrupteurs $SW_1$ et $SW_4$ sont fermés, la tension $V_S$ à la sortie O+ de l'amplificateur est égale à :

$$V_S = -\frac{C_1}{C_2} V_{IN} \qquad\qquad (10)$$

de sorte que si le rapport entre les capacités $C_1$ et $C_2$ est trop élevé, l'amplificateur opérationnel 32 risque de saturer.

La figure 9 représente un circuit à capacités commutées 35 correspondant à une variante du circuit 30 de la figure 7 dans lequel un interrupteur $SW_5$ est disposé aux bornes du condensateur $C_2$. L'interrupteur $SW_5$ est commandé par un signal de commande $P_3$. Pendant la durée $\alpha T_S$ pendant laquelle le signal $P_1$ est à l'état haut, le signal $P_3$ est à l'état bas (interrupteur $SW_5$ ouvert) pendant une durée $\beta \alpha T_S$, $\beta$ étant strictement inférieur à 1, puis est à l'état haut (interrupteur $SW_5$ fermé) pendant la durée $(1- \beta) \alpha T_S$. Pendant la durée $(1-\alpha)T_S$ pendant laquelle le signal $P_1$ est à l'état bas, le signal $P_3$ est à l'état haut (interrupteur $SW_5$ fermé). La valeur $\beta$ est choisie pour que le condensateur $C_2$ n'ait pas le temps de se charger complètement pendant la durée $\beta \alpha T_S$ de sorte que la tension $V_S$ n'atteigne pas des valeurs trop élevées susceptibles d'entraîner la saturation de l'amplificateur opérationnel 32. Pour un amplificateur opérationnel 32 classique, et pour un rapport $C_1/C_2$ égal à 10, $\beta$ peut être de l'ordre de 1/2.

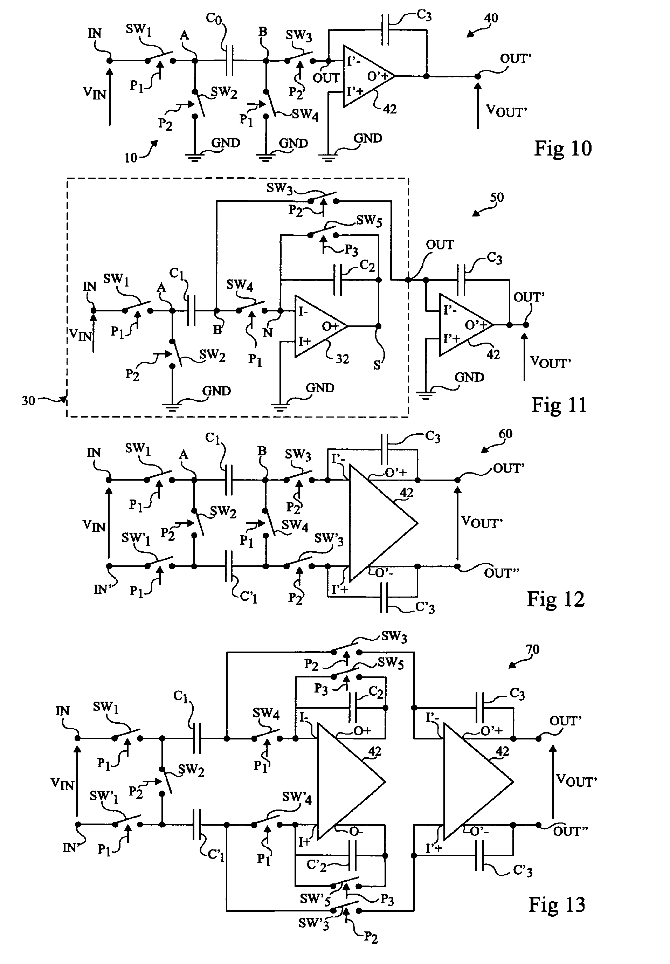

La figure 10 représente un exemple d'application classique du circuit à capacités commutées 10 de la figure 1 pour la réalisation d'un intégrateur 40. La borne OUT du circuit 10 est reliée à l'entrée inverseuse I'- d'un amplificateur opérationnel 42. L'entrée non inverseuse I'+ de l'amplificateur opérationnel 42 est reliée à la masse GND. Un condensateur $C_3$ est prévu entre l'entrée inverseuse I'- et une borne de sortie OUT' de l'intégrateur 40. La sortie O'+ de l'amplificateur opérationnel 42 est reliée à la borne OUT'.

Le fonctionnement de l'intégrateur 40 va maintenant être schématiquement décrit en supposant que la tension $V_{OUT'}$ est initialement égale à $V_0$ et en considérant que le signal $P_1$ est à l'état bas (signal $P_2$ à l'état haut). Les interrupteurs $SW_1$ et $SW_4$ sont alors ouverts et les interrupteurs $SW_2$ et $SW_3$ sont fermés. La charge stockée à l'armature droite du condensateur $C_0$ représentée à droite en figure 10 est nulle et la charge stockée à l'armature du condensateur $C_3$ représentée à gauche en figure 10 est égale à $-C_3 V_0$.

Lorsque le signal $P_1$ passe à l'état haut ($P_2$ à l'état bas), ou phase d'accumulation, les interrupteurs $SW_1$ et $SW_4$ sont fermés et les interrupteurs $SW_2$ et $SW_3$ sont ouverts. Les condensateurs $C_0$ et $C_3$ sont séparés. La charge $-C_3 V_0$ reste piégée sur l'armature gauche du condensateur $C_3$. La tension à la borne OUT' ne change pas. En outre, le condensateur $C_0$ se charge et l'armature droite du condensateur $C_0$ reçoit la charge $-C_0 V_{IN}$.

Lorsque le signal $P_1$ repasse à l'état bas ($P_2$ à l'état haut), ou phase d'intégration, les condensateurs $C_0$ et $C_3$ sont reliés à nouveau l'un à l'autre. La tension de sortie de l'amplificateur 42 passe alors à $V'_{OUT}$. Le bilan des charges entre les condensateurs $C_0$ et $C_3$ s'écrit :

$$0 - C_3 V'_{OUT} = -C_0 V_{IN} - C_3 V_0 \qquad (11)$$

soit :

$$V'_{OUT} = V_0 + (C_0/C_3) V_{IN} \qquad (12)$$

A chaque cycle de commutation des interrupteurs $SW_1$ à $SW_4$, la tension $V'_{OUT}$ est égale à la somme de la valeur du cycle précédent et d'un terme proportionnel à $V_{IN}$. On obtient donc bien le fonctionnement d'un intégrateur.

La figure 11 représente un exemple de réalisation d'un intégrateur 50 du type de celui représenté en figure 10, mettant en oeuvre le circuit 30 représenté en figure 9. Pour ce faire, la borne de sortie OUT du circuit 30 est reliée à l'entrée inverseuse I'- de l'amplificateur opérationnel 42.

Le fonctionnement du circuit 50 va maintenant être décrit. Lorsque le signal $P_1$ est à l'état haut pendant la durée $\alpha T_S$, c'est-à-dire pendant la phase d'acquisition, les interrupteurs $SW_1$ et $SW_4$ sont fermés et les interrupteurs $SW_2$ et $SW_3$ sont ouverts. Le circuit 30 n'est pas connecté à l'amplificateur opérationnel 42 et fonctionne comme cela a été décrit précédemment. Plus précisément, l'interrupteur $SW_5$ est ouvert pendant la durée $\beta \alpha T_S$ et est fermé pendant la durée $(1-\beta)\alpha T_S$.

Lorsque le signal $P_1$ est à l'état bas pendant la durée $(1-\alpha)T_S$, c'est-à-dire pendant la phase d'intégration, les interrupteurs $SW_1$ et $SW_4$ sont ouverts et les interrupteurs $SW_2$, $SW_5$ et $SW_3$ sont fermés. Le noeud B n'est plus relié au noeud N et le condensateur $C_1$ est relié à l'amplificateur opérationnel 42 de façon identique à ce qui a été décrit précédemment pour le condensateur $C_0$ du circuit 40. Les composantes hautes fréquences de bruit qui pourraient survenir pendant la phase d'intégration sont filtrées par l'amplificateur opérationnel 42.

La figure 12 représente un exemple de réalisation classique d'un intégrateur 60 ayant une structure différentielle. L'intégrateur 60 reprend les éléments du circuit 40 et comprend, en outre, un condensateur $C'_1$ dont une armature est reliée à une borne d'entrée IN' par un interrupteur $SW'_1$ et est reliée à l'interrupteur $SW_2$. L'autre armature du condensateur $C'_1$ est reliée à l'entrée non inverseuse I'+ de l'amplificateur différentiel 32 par l'intermédiaire d'un interrupteur $SW'_3$ et à l'interrupteur $SW_4$. L'interrupteur $SW'_1$ est commandé par le signal $P_1$ et l'interrupteur $SW'_3$ est commandé par l'interrupteur $P_2$. La sortie inverseuse I'- de l'amplificateur opérationnel 42 est reliée à une borne de sortie OUT". Un condensateur $C'_3$ est prévu entre l'entrée non inverseuse I'+ et la sortie inverseuse O'- de l'amplificateur opérationnel 42. Le fonctionnement de l'intégrateur 60 est identique à celui de l'intégrateur 40, le rôle joué par la masse GND pour l'intégrateur 40 étant joué dans ce cas par la tension de mode commun de l'amplificateur opérationnel 42.

La figure 13 représente l'utilisation du circuit 30 selon l'invention mis sous une forme différentielle pour la réalisation d'un d'intégrateur positif différentiel 70. L'intégrateur 70 reprend les éléments du circuit 60 et comprend, en outre, un interrupteur $SW'_4$ reliant le condensateur $C'_1$ à l'entrée non inverseuse I+ de l'amplificateur opérationnel 32. L'intégrateur 70 comprend, en outre, un condensateur $C'_2$ disposé entre l'entrée non inverseuse I+ et la sortie inverseuse O- de l'amplificateur opérationnel 32 et un interrupteur $SW'_5$ disposé aux bornes du condensateur $C'_2$. L'interrupteur $SW'_5$ est commandé par le signal $P_3$. Le fonctionnement de l'intégrateur 70 est identique à celui de l'intégrateur 50, le rôle joué par la masse GND pour l'intégrateur 40 étant joué dans ce cas par la tension de mode commun de l'amplificateur opérationnel 42.

La présente invention permet de réduire la contribution du bruit hautes fréquences dans la bande de fréquence du signal utile. De ce fait, pour un même SNR, il permet de réduire la capacité $C_1$ du circuit 30, 35 par rapport à la capacité $C_0$ du circuit 10. Dans le présent exemple de réalisation, la capacité $C_1$ peut être dix fois moins élevée que la capacité $C_0$. En outre, lorsque le circuit à capacités commutées est utilisé pour la réalisation d'un intégrateur, la capacité d'intégration $C_3$ peut être avantageusement réduite par rapport à un circuit classique, par exemple d'un facteur 10. De façon plus générale, l'utilisation du circuit à capacités commutées selon l'invention dans un système électronique peut permettre de réduire les capacités d'autres condensateurs du système électronique. La présente invention permet avantageusement de réduire la surface nécessaire pour réaliser de façon intégrée le circuit à capacités commutées 40, la surface occupée par l'amplificateur opérationnel 32 étant sensiblement équivalente à la surface occupée par un condensateur dont la capacité est de quelque picofarads.

La présente invention permet, en outre, d'obtenir un gain de consommation de l'ordre de 7 à 8 par rapport à un circuit à capacités commutées classique. La consommation du circuit n'est pas réduite exactement du rapport de capacités $C_1/C_2$ puisqu'il faut tenir compte de la consommation de l'amplificateur opérationnel 32. De plus, lorsque le circuit à capacités commutées correspond à un étage d'un système électronique comprenant plusieurs étages successifs, la réduction de la capacité d'entrée du circuit à capacités commutées permet de réduire les contraintes sur l'étage qui précède le circuit à capacités commutées, par exemple un préamplificateur.

Des modes de réalisation particuliers de la présente invention ont été décrits. Diverses variantes et modifications apparaîtront à l'homme de l'art. En particulier, bien qu'un exemple de circuit à capacités commutées comprenant quatre interrupteurs $SW_1$ à $SW_4$ a été décrit, il est clair que la présente invention peut s'appliquer à un circuit à capacités commutées dans lequel une même armature du condensateur C1 est commutée entre les bornes IN et OUT, l'autre armature du condensateur $C_1$ étant alors reliée à l'entrée inverseuse I- de l'amplificateur opérationnel 32.

## Revendications

1. Circuit à capacités commutées (30 ; 35) comprenant au moins un premier condensateur ($C_1$) ;
   des bornes d'entrée, de masse et de sortie (IN, GND, OUT) ;
   un circuit de commutation ($SW_1$ ,SW2) d'une première armature du premier condensateur alternativement vers l'entrée (IN) et vers la masse (GND), respectivement pendant des premières phases (P1) et pendant des deuxièmes phases (P2) d'un signal de commutation à une fréquence $f_S$, les premières et deuxièmes phases étant non recouvrantes ;
   un deuxième condensateur ($C_2$) ;
   un troisième interrupteur ($SW_3$) reliant la seconde armature du premier condensateur à la borne de sortie (OUT) ;
   un quatrième interrupteur (SW4) reliant la seconde armature du premier condensateur à une première armature du deuxième condensateur au niveau d'un noeud (N), le quatrième interrupteur étant commandé pendant lesdites premières phases (P1) et le troisième interrupteur étant commandé pendant lesdites deuxièmes phases (P2) ; et
   un circuit de filtrage (32) reliant ledit noeud (N) à une masse virtuelle (GND) seulement pendant les premières phases du signal de commutation, ces premières phases étant les phases de mémorisation du signal de ladite entrée (IN) dans le premier condensateur ($C_1$).

2. Circuit selon la revendication 1, dans lequel le circuit de commutation ($SW_1$ ,SW2) comprend :

   un premier interrupteur ($SW_1$) reliant la première borne (IN) à la première armature du premier condensateur ; et
   un deuxième interrupteur ($SW_2$) reliant la deuxième borne (GND) à la première armature du premier condensateur ;

3. Circuit selon la revendication 1, dans lequel le circuit de filtrage (32) est adapté à relier le noeud à la masse virtuelle (GND) seulement pour des fréquences inférieures à une fréquence de seuil ($f'_C$) supérieure à la moitié de la fréquence de commutation ($f_S$).

**4.** Circuit selon la revendication 3, dans lequel le circuit de filtrage (32) comprend un amplificateur à entrées différentielles dont une entrée est reliée au noeud (N) et ayant une fréquence de coupure principale, la fréquence de seuil ($f'_C$) du circuit de filtrage correspondant à la fréquence de coupure principale.

**5.** Circuit selon l'une quelconque des revendications 1 à 4, dans lequel le circuit de filtrage (32) comprend au moins un filtre actif comportant au moins un composant électronique actif et au moins un filtre passif comportant au moins un composant électronique passif.

**6.** Circuit selon l'une quelconque des revendications 1 à 4, dans lequel la capacité du deuxième condensateur ($C_2$) est inférieure à la capacité du premier condensateur ($C_1$).

**7.** Circuit selon la revendication 2, dans lequel le circuit de filtrage comprend un amplificateur opérationnel (32) comprenant une entrée (I-) reliée audit noeud (N) et une sortie (O+) reliée à ladite entrée par l'intermédiaire du deuxième condensateur ($C_2$), la fréquence de seuil ($f'_C$) du circuit de filtrage correspondant à la fréquence de coupure de l'amplificateur opérationnel.

**8.** Circuit selon la revendication 7, dans lequel la deuxième borne est reliée à une source (GND) du potentiel de référence et dans lequel l'amplificateur opérationnel (32) comprend une entrée supplémentaire (I+) reliée à ladite source du potentiel de référence.

**9.** Circuit selon la revendication 7 ou 8, comprenant, en outre, un cinquième interrupteur ($SW_5$) aux bornes du deuxième condensateur ($C_2$), le cinquième interrupteur étant fermé, lorsque les premier et quatrième interrupteurs ($SW_1$, $SW_4$) sont fermés, pendant une première durée et ouverts pendant une seconde durée.

**10.** Circuit selon l'une quelconque des revendications 2 à 9, comprenant, en outre :

un troisième condensateur ($C'_1$) comprenant des troisième et quatrième armatures, l'amplificateur opérationnel (32) comprenant une entrée supplémentaire (I+) reliée à un noeud supplémentaire et une sortie supplémentaire (O-) reliée à l'entrée supplémentaire par l'intermédiaire d'un quatrième condensateur ($C'_2$) ;
des quatrième et cinquième bornes (IN') ;
un sixième interrupteur ($SW'_1$) commandé par le premier signal (P1) reliant la quatrième borne (IN') à la troisième armature du troisième condensateur ;
un septième interrupteur ($SW'_3$) commandé par le second signal ($P_2$) reliant la cinquième borne à la quatrième armature du troisième condensateur ; et
un huitième interrupteur ($SW'_4$) commandé par le premier signal reliant le noeud supplémentaire à la quatrième armature du troisième condensateur, la deuxième borne étant située entre la troisième armature du troisième condensateur et le cinquième interrupteur.

**Claims**

**1.** A switched-capacitor circuit (30; 35) comprising at least one first capacitor (C1);
input, ground and output terminals (IN, GND, OUT);
a switching circuit ($SW_1$, $SW_2$) for switching a first armature of the first capacitor alternately towards an input (IN) and towards the ground (GND), respectively during first phases (P1) and during second phases (P2) of a switching signal at a frequency $f_S$, the first and second phases being nonoverlapping;
a second capacitor ($C_2$);
a third switch ($SW_3$) connecting the second armature of the first capacitor to the output terminal (OUT);
a fourth switch ($SW_4$) connecting the second armature of the first capacitor to a first armature of the second capacitor at a node (N), the fourth switch being controlled during said first phases (P1) and the third switch being controlled during said second phases (P2); and
a filtering circuit (32) connecting said node (N) to a virtual ground (GND) only during the first phases of the switching signal, these first phases being the phases of signal storage of said input (IN) in the first capacitor ($C_1$).

**2.** The circuit of claim 1, wherein the switching circuit ($SW_1$, $SW_2$) comprises:

a first switch ($SW_1$) connecting the first terminal (IN) to the first armature of the first capacitor; and
a second switch ($SW_2$) connecting the second terminal (GND) to the first armature of the first capacitor.

3. The circuit of claim 1, wherein the filtering circuit (32) is adapted for connecting the node to the virtual ground (GND) only for frequencies smaller than a threshold frequency ($f'_C$) greater than half the switching frequency ($f_S$).

4. The circuit of claim 3, wherein the filtering circuit (32) comprises an amplifier with differential inputs having an input connected to the node (N) and having a main cut-off frequency, the threshold frequency ($f'_C$) of the filtering circuit corresponding to the main cut-off frequency.

5. The circuit of any of claims 1 to 4, wherein the filtering circuit (32) comprises at least one active filter comprising at least one active electronic component and at least one passive filter comprising at least one passive electronic component.

6. The circuit of any of claims 1 to 4, wherein the capacitance of the second capacitor ($C_2$) is smaller than the capacitance of the first capacitor ($C_1$).

7. The circuit of claim 2, wherein the filtering circuit comprises an operational amplifier (32) comprising an input (I-) connected to said node (N) and an output (O+) connected to said input via the second capacitor ($C_2$), the threshold frequency ($f'_C$) of the filtering circuit corresponding to the cut-off frequency of the operational amplifier.

8. The circuit of claim 7, wherein the second terminal is connected to a source (GND) of the reference voltage and wherein the operational amplifier (32) comprises an additional input (I+) connected to said source of the reference voltage.

9. The circuit of claim 7 or 8, further comprising a fifth switch ($SW_5$) across the second capacitor ($C_2$), the fifth switch being on, when the first and fourth switches ($SW_1$, $SW_4$) are on, for a first time period and off for a second time period.

10. The circuit of any of claims 2 to 9, further comprising:

> a third capacitor ($C'_1$) comprising third and fourth armatures, the operational amplifier (32) comprising an additional input (I+) connected to an additional node and an additional output (O-) connected to the additional input via a fourth capacitor ($C'_2$);
> fourth and fifth terminals (IN');
> a sixth switch ($SW'_1$) controlled by the first signal ($P_1$) connecting the fourth terminal (IN') to the third armature of the third capacitor;
> a seventh switch ($SW'_3$) controlled by the second signal ($P_2$) connecting the fifth terminal to the fourth armature of the third capacitor; and
> an eighth switch ($SW'_4$) controlled by the first signal connecting the additional node to the fourth armature of the third capacitor, the second terminal being located between the third armature of the third capacitor and the fifth switch.

**Patentansprüche**

1. Ein Schaltkreis (30; 35) mit geschalteten Kapazitäten, wobei Folgendes vorgesehen ist:

> mindestens ein erster Kondensator (C1);
> Eingangs-, Erd- und Ausgangsanschlüsse (IN, GND, OUT);
> ein Schaltkreis ($SW_1$, $SW_2$) zum Schalten eines ersten Anschlusses des ersten Kondensators, alternativ zu dem Eingang (IN) bzw. zur Erde (GND) während der ersten Phasen (P1) und während der zweiten Phasen (P2) eines Schaltsignals mit einer Frequenz $f_s$, wobei die ersten und zweiten Phasen nicht überlappend sind;
> ein zweiter Kondensator ($C_2$);
> ein dritter Schalter ($SW_3$) der den zweiten Anschluss des ersten Kondensators mit dem Ausgangsanschluss (OUT) verbindet;
> ein vierter Schalter ($SW_4$), der den zweiten Anschluss des ersten Kondensators mit einem ersten Anschluss des zweiten Kondensators an einen Knoten (N) verbindet, wobei der vierte Schalter, während der ersten Phasen (P1) gesteuert wird, und wobei der dritte Schalter, während der zweiten Phasen (P2) gesteuert wird; und
> eine Filterschaltung (32), die den Knoten (N) mit einer virtuellen Erde (GND) verbindet und zwar nur während der ersten Phasen des Schaltsignals, wobei diese ersten Phasen die Phasen des Signalsspeichers des ersten Eingangs (IN) zum ersten Kondensator ($C_1$) sind.

2. Der Schaltkreis nach Anspruch 1, wobei der Schaltkreis ($SW_1$, $SW_2$) Folgendes aufweist:

einen ersten Schalter ($SW_1$), der den ersten Anschluss (IN) mit dem ersten Anschluss des ersten Kondensators verbindet; und
einen zweiten Schalter ($SW_2$), der den zweiten Anschluss (GND) mit dem ersten Anschluss des ersten Kondensators verbindet.

3. Der Schaltkreis nach Anspruch 1, wobei die Filterschaltung (32) geeignet ist zur Verbindung des Knotens mit der virtuellen Erde (GND) nur für Frequenzen, die kleiner sind als eine Schwellenfrequenz ($f'_C$), die größer ist als die Hälfte der Schaltfrequenz ($f_S$).

4. Der Schaltkreis nach Anspruch 3, wobei die Filterschaltung (32) einen Verstärker aufweist, mit Differentialeingängen, mit einem Eingang und mit dem Knoten (N) und mit einer Haupttrennfrequenz, wobei die Schwellenfrequenz ($f'_C$) der Filterschaltung der Haupttrennfrequenz entspricht.

5. Der Schaltkreis nach einem der Ansprüche 1 bis 4, wobei die Filterschaltung (32) mindestens einen aktiven Filter aufweist, der mindestens eine aktive elektronische Komponente und mindestens einen passiven Filter aufweist, der mindestens eine passive elektronische Komponente aufweist.

6. Der Schaltkreis nach einem der Ansprüche 1 bis 4, wobei die Kapazität des zweiten Kondensators ($C_2$) kleiner ist als die Kapazität des ersten Kondensators ($C_1$).

7. Der Schaltkreis nach Anspruch 2, wobei die Filterschaltung einen Betriebsverstärker (32) aufweist, der einen Eingang (I-) verbunden mit dem Knoten (N) und einen Ausgang (O+) verbunden mit dem Eingang über den zweiten Kondensator ($C_2$) aufweist, wobei die Schwellenfrequenz ($f'_C$) der Filterschaltung der Trennfrequenz des Betriebsverstärkers entspricht.

8. Der Schaltkreis nach Anspruch 7, wobei der zweite Anschluss mit einer Source (GND) der Bezugsspannung verbunden ist, und wobei der Betriebsverstärker (32) einen zusätzlichen Eingang (I+) aufweist, verbunden mit der erwähnten Quelle der Bezugsspannung.

9. Der Schaltkreis nach Anspruch 7 oder 8, wobei ein fünfter Schalter ($SW_5$) vorgesehen ist, über den zweiten Kondensator ($C_2$) hinweg, wobei der fünfte Schalter Ein dann ist, wenn die ersten und vierten Schalter ($SW_1$, $SW_4$) Ein sind und zwar für eine erste Zeitperiode und Aus für eine zweite Zeitperiode.

10. Der Schaltkreis nach einem der Ansprüche 2 bis 9, wobei ferner Folgendes vorgesehen ist:

ein erster Kondensator ($C'_1$) der dritte und vierte Anschlüsse aufweist, wobei der Betriebs- bzw. Operationsverstärker (32) einen zusätzlichen Eingang (I+) und einen zusätzlichen Ausgang (O-) aufweist, wobei der zusätzliche Eingang (I+) mit einem zusätzlichen Knoten verbunden ist, und wobei der zusätzliche Ausgang (O-) mit dem zusätzlichen Eingang über einen vierten Kondensator ($C'_2$) verbunden ist;
vierte und fünfte Anschlüsse (IN');
ein sechster Schalter ($SW'_1$) gesteuert durch das erste Signal ($P_1$) und zwar den vierten Anschluss (IN') mit dem dritten Anschluss des dritten Kondensators verbindend;
ein siebter Schalter ($SW'_3$) gesteuert durch das zweite Signal ($P_2$) und zwar den fünften Anschluss mit dem vierten Anschluss des dritten Kondensators verbindend; und
ein achter Schalter ($SW'_4$) gesteuert durch das erste Signal und zwar den zusätzlichen Knoten mit dem vierten Anschluss des dritten Kondensators verbindend, wobei der zweite Anschluss zwischen dem dritten Anschluss des dritten Kondensators und dem fünften Schalter, angeordnet ist.

SW₁    A    C₀    B    SW₃                    ↙ 10

IN                                          OUT

P₁

V_IN                    SW₂              P₂

                P₂          P₁        SW₄

GND

GND            ⌐GND  ⌐GND              GND

Fig 1

IN        R_on
                              C₀

V_IN          S_b                          ↙ 12

                          GND    V_OUT

Fig 2

S₁

          f_N/2  f_S/2    f_S        f_C        f

Fig 3

SW₁    A    C₁    B    SW₃                    ↙ 14

IN                                          OUT

P₁

V_IN                    SW₂              P₂

                P₂          P₁        SW₄

GND                              N        C₂

GND            ⌐GND  ⌐GND              V_OUT

Fig 4

          R_on
IN                    A                      ↙ 16
                              C₁        V_OUT

V_IN    S_b    V'_OUT        B,N
                              C₂

          GND              GND

Fig 5

Fig 6

Fig 7

Fig 8

Fig 9

Fig 10

Fig 11

Fig 12

Fig 13

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 63299406 B